(19) Europäisches Patentamt
European Patent Office
Office européen des brevets

(11) **EP 2 043 239 B1**

(12) **EUROPEAN PATENT SPECIFICATION**

(45) Date of publication and mention
of the grant of the patent:
**10.02.2010 Bulletin 2010/06**

(51) Int Cl.:
*H02M 1/08* (2006.01)    *H02M 7/162* (2006.01)
*H02M 7/219* (2006.01)    *H02M 7/757* (2006.01)
*H02M 7/797* (2006.01)    *G01R 19/175* (2006.01)
*H02J 3/40* (2006.01)

(21) Application number: **07117326.4**

(22) Date of filing: **27.09.2007**

(54) **Method in connection with mains side converter**

Verfahren für einen mit dem Versorgungsnetz verbundenen Stromrichter

Procédé pour un convertisseur connecté avec le réseau électrique

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**01.04.2009 Bulletin 2009/14**

(73) Proprietor: **ABB Oy**
**00380 Helsinki (FI)**

(72) Inventor: **Viitanen, Tero**
**01710, Vantaa (FI)**

(74) Representative: **Valkeiskangas, Tapio Lassi Paavali**
**Kolster Oy Ab**
**Iso Roobertinkatu 23**
**P.O. Box 148**
**00121 Helsinki (FI)**

(56) References cited:
**DE-A1- 3 236 071       DE-A1- 10 048 441**
**US-A1- 2003 075 997    US-B1- 6 459 599**

**Description**

FIELD OF THE INVENTION

The present invention relates to a method for determining properties of an alternating three-phase supply network, and particularly to a method with which a mains side converter of a frequency converter can be synchronized with the alternating three-phase supply network.

BACKGROUND OF THE INVENTION

A frequency converter consists of a mains side converter, an intermediate voltage circuit and an inverter. The mains side converter converts alternating input voltage to a DC-voltage of the intermediate voltage circuit also called as a DC-link. The voltage of the DC-link is further used for producing alternating voltage for the load. The alternating voltage is generated by using the inverter. Often it is also desirable to be able to feed power back to the supply network, or to control the reactive power drawn from the main or the improve the input power factor by shaping the input current, in which case the mains side converter can implemented with controllable switches and the structure of which is similar to that of the inverter.

In a situation where the frequency converter is taken into use, the intermediate voltage circuit is without any charge thus the DC-voltage is zero. The capacitor of the DC-link has to be charged before any control operations can be carried out. Charging of the DC-link can be carried out for example by using the supply voltage connected to the DC-link via a charging resistor which limits the charging current from the supply. After the DC-link capacitor is charged to the normal operation value, the mains side converter has to be synchronized to the alternating voltage of the supply. This means that the properties, including frequency and phase sequence, of the alternating voltage have to be determined.

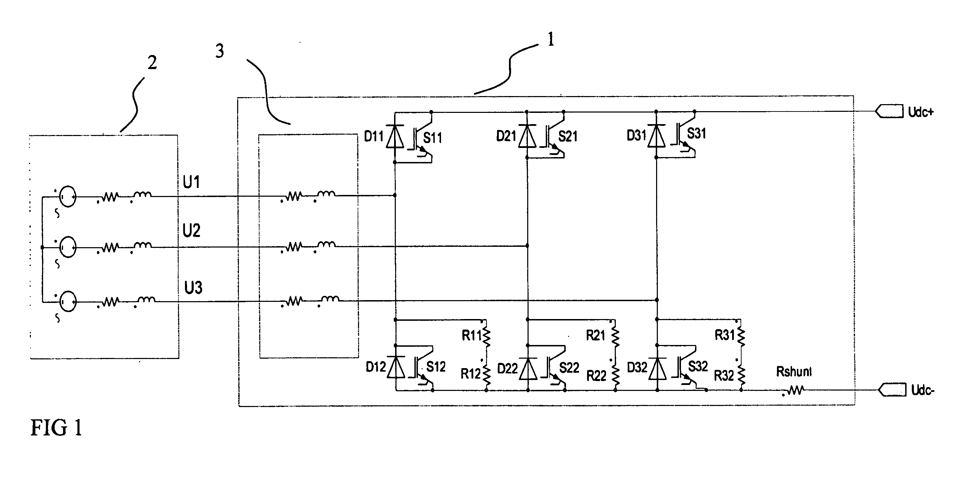

Figure 1 shows a simplified equivalent circuit of a mains side converter 1 and alternating supply voltage 2 with phases U1, U2 and U3. In Figure 1 the mains side converter consists of active gate commutated semiconductor switches S11, S29, S31 in the upper branch and S12, S22, S32 in the lower branch, and parallel diodes D11, D21, D31 in the upper branch and D21, D22, D32 in the lower branch. The state information of the semiconductor switches, which is used for example to determine the switching time delays and possible malfunctions of the switches, is measured using high ohmic measurement resistor circuit R11, R12; R21, R22; R31, R32 in parallel with each of the semiconductor switching components in the lower branch. These resistor circuits in Figure 1 comprise two resistors in series and produce thus resistive voltage division of the voltage over the lower branch switches. It is clear, however, that resistive voltage division may comprise different number of resistances depending on the need. Further, in Figure 1, a filter 3 is placed between the mains voltage and the converter.

When the active states of the converter switches are changed with some modulation scheme, the phase inputs of the converter are connected to either high intermediate voltage potential Udc+ or to low intermediate voltage potential Udc- through the controllable switches. The differing voltages between the supply and intermediate circuit can cause currents that may have very high values. In order to keep the currents in a tolerable range, the control system of the converter must be synchronized with its alternating three-phase supply voltage.

Stable and smooth load control requires thus the converter control system to be synchronized with the alternating supply voltage. Synchronization is typically implemented with some sort of converter test voltage pulses applied to mains side of the converter, whose current response is measured and from this, the alternating voltage of the mains is approximated. International publication WO 94/03965 discloses one such method in connection with inverter of the frequency converter.

The above synchronization method requires switching of the active switches and also accurate and synchronized mains current measurements. Furthermore, the application of the first output voltage can lead to high currents if the direction and magnitude of the applied voltage is not chosen correctly.

In some supply converters the phase currents are not directly measured due to the expenses of the current measurement elements. The current can be measured in normal operation for the purposes of converter control circuit using only one current measurement from the DC-intermediate circuit using a shunt resistor. Figure 1 also includes shunt resistor $R_{shunt}$, the voltage over it being directly proportional to a current of one converter phase when one or two phases is connected to lower potential Udc- of the intermediate circuit, i.e. when either semiconductor switch or diode of the phase or phases in question are in a conductive state.

The usability of the above current measurement method is limited by the dependence between current information and usable switching states. If, for example, all phases of the converter are connected at the same time either to Udc+ or Udc- potential, there is no current through the shunt resistor although current is flowing in the phases of the supply voltage. This limitation due to the current measurement precludes the use of known synchronization methods, where test pulses are applied and the current response is measured.

Document DE 10048441 discloses a method for detecting the voltage of a semiconductor component in a series connection of semiconductor components.

Document US 2003/0075997 A1 discloses an alternator system in which a switched-mode rectifier is controlled to provide a pulse sequence which is synchronized with the angular rotor position of the alternator.

BRIEF DESCRIPTION OF THE INVENTION

An object of the present invention is to provide a method so as to overcome the above problems relating to the synchronization of a mains side converter with a alternating voltage supply. The objects of the invention are achieved by a method which is characterized by what is stated in the independent claim. The preferred embodiments of the invention are disclosed in the dependent claims.

The invention is based on the idea that the properties of alternating supply voltage can be determined by using resistors already present in the circuitry of a mains side converter. The determination of the properties is possible when the intermediate voltage of the frequency converter is equal to or higher than the line-to-line voltage of the supply voltage.

An advantage of the method of the invention is that it is very simple in structure and it allows for a fast determination of the properties of the alternating supply network that are needed for full synchronization of the converter. The method requires only a minimal amount of additional elements and does not require the phase currents to be measured separately.

BRIEF DESCRIPTION OF THE DRAWINGS

In the following the invention will be described in greater detail by means of preferred embodiments with reference to the attached drawings, in which

Figure 1 is a simplified equivalent circuit of a mains side converter and an alternating three-phase supply network;
Figures 2 and 3 show the voltage of the intermediate circuit during its charging;
Figures 4 and 6 show alternating mains voltages and the mains voltages in the converter;
Figure 5 shows a voltage space vector diagram;
Figure 7 shows an example of a circuit for determination of the alternating voltage magnitude; and
Figure 8 shows the voltages in the resistive circuit during the charging of the intermediate circuit.

DETAILED DESCRIPTION OF THE INVENTION

Figure 1 shows an equivalent circuit of mains side converter and an alternating three-phase supply voltage connected to the converter. The converter feeds an intermediate voltage circuit providing voltages Udc+ and Udc- to the load, such as an inverter, which is not shown. In Figure 1 current is measured using a single shunt resistor Rshunt in the lower DC-bus.

The state of the converter active semiconductor switches is typically measured by using a resistive voltage division measurement across the lower arm IGBTs S12, S22, S32 and free-wheeling diodes D12, D22, D32 as shown in simplified schematic in Figure 1. This state information is used e.g. to approximate the commutation and switching delays. The same voltage measurement configuration can be used also for synchronization purposes according to the present invention.

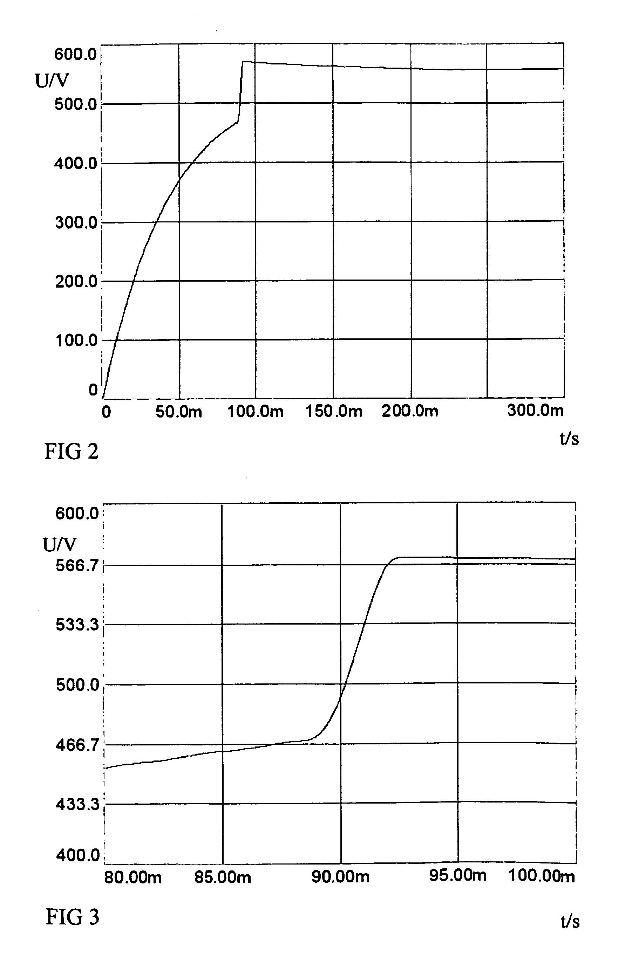

When a frequency converter is started, the intermediate circuit has to be first charged. The charging can be carried out by placing a charging resistor in series with the capacitor of the intermediate circuit. Three-phase supply voltage then charges the capacitor through the free-wheeling diodes and the resistor. This voltage build-up is shown in Figures 2 and 3.

Figure 2 shows the increasing voltage in a larger scale and Figure 3 is a partial reproduction of Figure 2 at the time when the charging resistor is by-passed. In Figures 2 and 3 the charging resistor is by-passed approximately at t = 89ms, at which instant the voltage starts to increase more rapidly towards the value of rectified mains voltage.

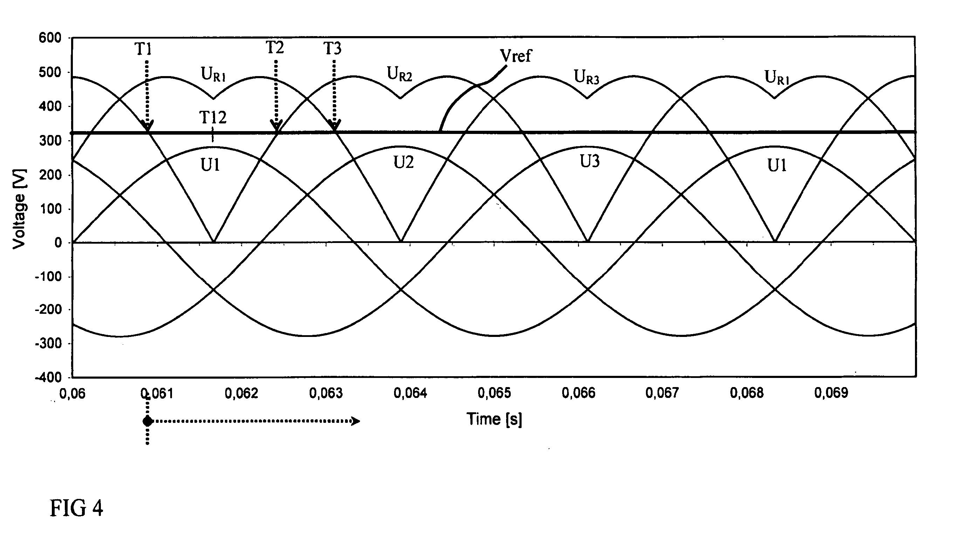

As can be seen from the Figures 2 and 3, the voltage rises a little bit over the value of the rectified mains voltage due to inductances in the current path. This overshoot of voltage further means that the free-wheeling diodes D11, D21, D31, D12, D22, D32 of the mains side converter are in blocking state and there is no current flow in the main circuit due to the alternating supply voltage. However, the alternating supply voltage can be seen across the lower arm resistors as indicated in Figure 4, where the sinusoidal signals represent the phase voltages U1, U2, U3 of the alternating supply voltage and the other signals the voltages across the resistors $U_{R1}$, $U_{R2}$, $U_{R3}$ of corresponding phases respectively. The voltages of the resistors are measured in the potential of the lower DC-bus.

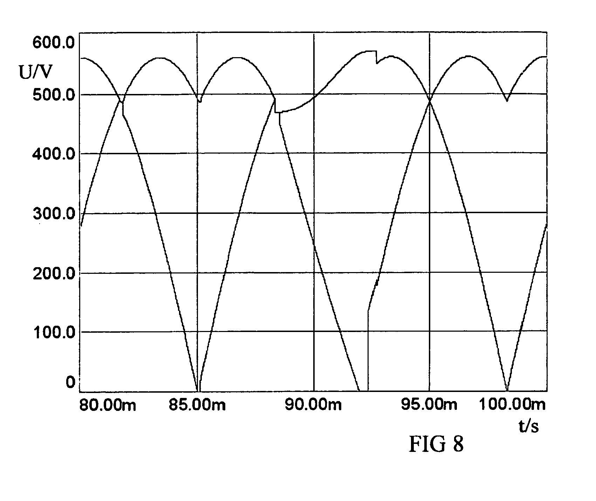

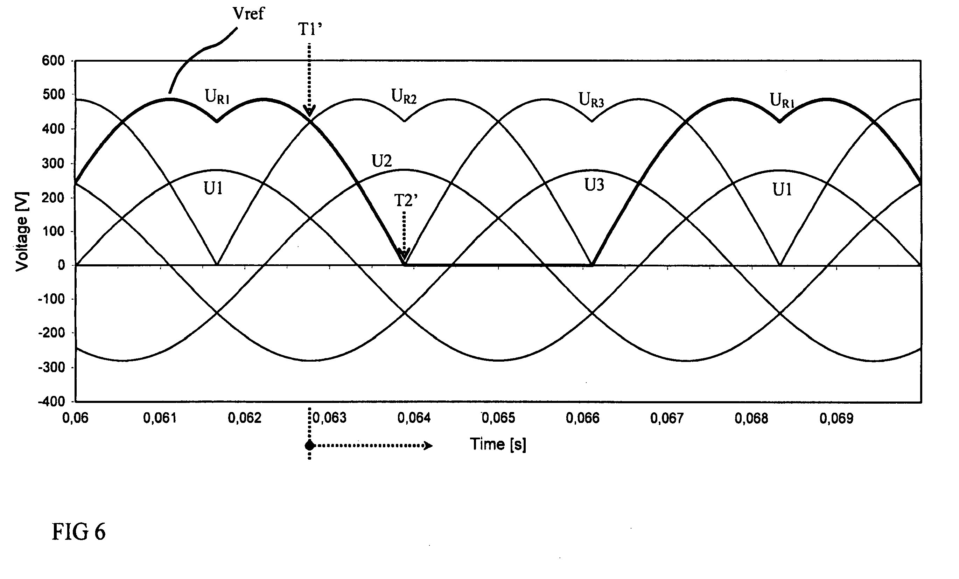

Figure 8 shows the voltage waveforms across the resistors during the charging of the intermediate voltage circuit. The voltage waveforms are distorted until the time instant, when the charging resistor is by-passed and the voltage of the intermediate circuit has reached its operational value (approximately at t = 94ms). After that time instant the voltages in the resistive circuits are as indicated in Figures 4 and 6.

The method of the invention thus requires that the voltage of the intermediate circuit is equal to or higher than the alternating supply voltage, since the upper free-wheeling diodes need to be in the blocking state as mentioned above.

At the beginning of the method of the invention the rotational state of the supply network or voltages of the alternating mains is unknown.

In the method of the invention a voltage limit Vref is defined. This voltage limit is shown in Figure 4. Further, the voltages $U_{R1}$, $U_{R2}$, $U_{R3}$ produced by the alternating mains voltage and seen in the resistive circuits are compared with the voltage limit. Resistive circuits comprise resistive voltage divider circuits, i.e. at least two series-connected resistors. The purpose of the resistive circuit in connection with the invention is to produce a voltage that is proportional to the voltage of the alternating mains voltage, and, furthermore, to lower the voltage level suitable for control electronics.

When the comparison between the voltages and the voltage limit has begun, a first time instant T1 is determined when the voltage of any of the resistive circuits crosses the voltage limit. The voltages $U_{R1}$, $U_{R2}$, $U_{R3}$ in all of the resistive circuits are compared with the voltage limit Vref and when one of the mentioned voltages crosses the limit the time instant of that crossing is determined.

Since the procedure begins in a state where the rotational properties of the supply voltage are unknown, also the phase the voltage of which crossed the limit is determined. Each phase has a separate resistive circuit and the determination of the phase is thus a simple task. Also in connection with the crossing the direction of the crossing is determined. That is to say, it is determined, if the voltage that crossed the voltage limit had a rising or falling slope.

In the method of the invention the voltages of the resistive circuits are continuously monitored against the voltage limit after the first time instant. The second time instant T2 when the voltage of any of the resistive circuits crosses the voltage limit is also determined. The phase that crossed the voltage limit is also determined together with the direction of the crossing, similarly as in case of the first time instant.

After these two time instants the phase sequence of the supply voltage can be determined. The phase sequence refers in a known manner to the direction of rotation. The phase sequence is determined based on the knowledge that all the three phases cross the voltage limit one after the other depending on the direction of the crossings, i.e. if the first phase that crosses the limit is U2 and the second phase is U1, then the next one will be U3. If, for example, this is the order of the first two crossings (U2, U1), then it can be determined that the next crossing will be from the voltage of phase U3. The compared voltages are the voltages from the resistive circuits, i.e. voltages $U_{R1}$, $U_{R2}$ and $U_{R3}$. These voltages are derived directly from the alternating supply voltages (U1, U2 and U3) and therefore the order of the voltages in the resistive circuits gives the order of the phases.

Since the consecutive crossings have different directions, the direction of the third crossing is the same as that of the first one. The first and the third crossings having the same direction, the order of the phases is: the phase that crossed first, the phase that will cross third and the phase that crossed second. In the above example the phase sequence is thus U2, U3, U1.

According to the method of the invention, after the two time instants T1, T2 a peak time instant T12 is calculated. This peak time is a time instant in the middle of the first time instant T1 and second time instant T2. Due to the symmetry of the voltage curves, between every two consecutive crossings the third phase voltage has a peak value which is either negative or positive. Whether the peak is positive or negative can be determined from the direction of the first crossing that occurred at the first time instant. If the direction of the first crossing is such that the voltage goes below the voltage limit, then the peak voltage is positive. If, on the other hand, the direction of the first crossing is such that the voltage is rising, then the peak voltage is negative.

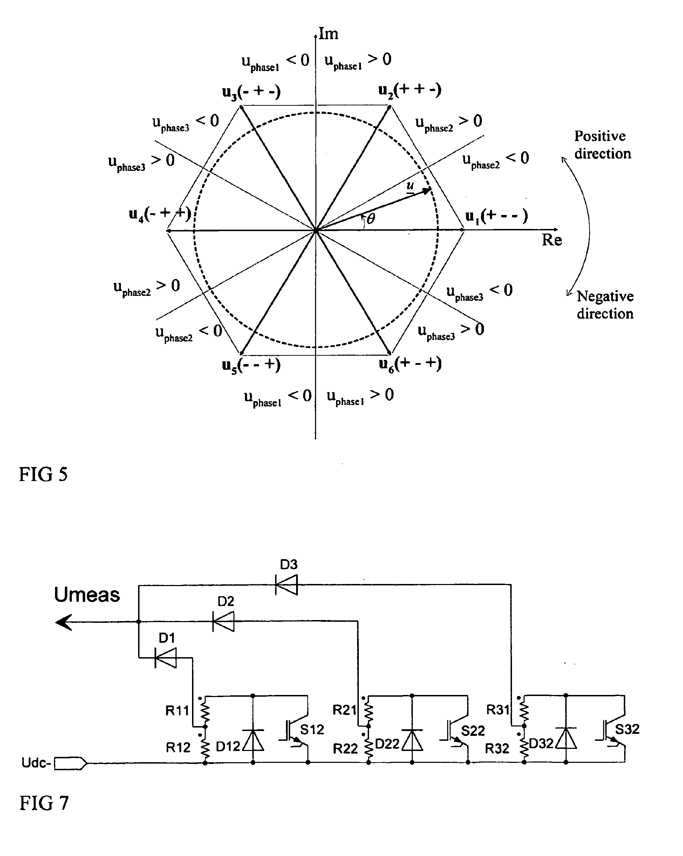

Figure 5 illustrates a voltage space vector $\underline{u}$, sometimes also called as space phasor. As known in the art, space vectors are rotating vectors in a complex plane that have a length and a direction. A space vector for a variable x of a three phase system having phases a, b and c is constructed using equation

$$\underline{x} = \frac{2}{3}\left(x_a + \underline{a}x_b + \underline{a}^2 x_c\right) = |\underline{x}|e^{j\theta},$$

where

$$\underline{a} = e^{j2\pi/3} = -\frac{1}{2} + j\frac{\sqrt{3}}{2}, \quad \underline{a}^2 = e^{j4\pi/3} = -\frac{1}{2} - j\frac{\sqrt{3}}{2}$$

and $|\underline{x}|$ is the length of the space vector and $\theta$ is the angle between the vector and the positive real axis. The active voltage vectors of a supply converter produce the vector diagram of Figure 5.

Figure 5 shows also the positive and negative phase sequences and the polarities of phase voltages. As known, the magnitudes of the phase voltages can be directly calculated from the rotating space vector.

Since at time instant T12 one of the phase voltages has a positive or negative peak value, the angle of the rotating space vector is also known at that instant. It can be seen from Figure 5 that if, for example, phase U2 has a negative peak value at instant T12, then the angle of the voltage space vector is -60°.

According to the method of the invention third time instant T3 is determined similarly as the first two instants. As already mentioned, the first and third crossings have the same direction i.e. the voltage in the resistive circuit either rises or falls at both the first and third time instants. In the preferred embodiment of the invention the frequency of the rotation of the alternating supply voltage is calculated from the first and third time instants. The time difference between the first and third time instants (T3 - T1) is one third of the full rotation of alternating supply. The time period for the full rotation of the alternating supply voltage is thus three times the said difference. Thus the electrical frequency f of the alternating supply voltage can be calculated as

$$f = \frac{1}{3 \times (T3 - T1)}.$$

The above embodiment determines the frequency quickly and is thus very usable when the mains side converter has to be synchronized with the alternating supply network quickly.

In another embodiment the frequency of the supply network is calculated by measuring further time instants where any of the voltages of the resistive circuits crosses the voltage limit as described above. Then every other crossing time instant is selected and fed to a phase-locked loop, which determines the frequency. Every other crossing means, in principle, that either rising or falling voltage slopes are taken into account. The phase-locked loop outputs the information on the frequency

Now that the frequency, phase sequence and angle of the alternating supply network at time instant T12 are known, the angle of the voltage of the supply network, i.e. the angle of the space vector, can be calculated at a given time instant *t* with the following formula

$$Angle(t) = Angle12 + k(t - T12) \times 2\pi f,$$

where Angle 12 is the angle of the space vector at the time instant T12 and k is a coefficient indicating the phase sequence, and its value is 1 when the phase sequence is positive and -1 when the phase sequence is negative.

With the above formula the angle of the alternating voltage can be calculated for example for synchronization purposes so that the converter control can be started.

According to another embodiment each of the voltages in the resistive circuits are A/D converted. In the conversion the analogue signals are digitized and the maximum value of the conversion is then considered as the amplitude of the alternating line-to-line voltage.

Figure 7 shows a dedicated measurement arrangement, in which the voltages of the resistive circuits are fed according to one embodiment of the invention. In this embodiment the voltages from the resistive circuits are fed to a common point through diodes D1, D2, D3. The basic rectifying function of the diodes D1, D2, D3 can be replaced with alternative circuit arrangements (e.g. operational amplifiers) that perform the same function. The voltage at the common point forms the voltage Umeas and it is basically the envelope of voltages in the resistive circuits $U_{R1}$, $U_{R2}$, $U_{R3}$. By measuring the envelope voltage the amplitude of the mains voltage can be determined at a first possible instant using only one measurement. Fast voltage measurement is needed if the information of the amplitude is used for synchronization purposes and when the synchronization with the inverter is done after the third time instant. Usually, the voltage level of the supply network is known also beforehand.

The measurement of the peak voltage gives the maximum line-to-line supply voltage from which the phase-to-neutral voltage can be obtained by dividing it by √3. The voltage can also be easily determined from the converter DV-link voltage.

It is preferable that the voltage limit Vref is adjustable. The adjustability of the voltage limit allows the method to be implemented in different situations. If it is foreseen that the mains voltage is high in amplitude, a higher voltage limit is also chosen, and, on the other hand, if the mains voltage amplitude is lower, a lower voltage limit should be chosen.

In the following, a simple sequence according to the invention is described with reference to Figure 4. First, the procedure is initialized for example in response to knowledge of the charged intermediate voltage circuit after a request made to a frequency converter to start the control of the mains side converter. First crossing of the limit voltage is noticed at time instant T1 where voltage $U_{R3}$ drops below the limit voltage. A timer is started and T1 is set to zero.

Second limit voltage crossing is noticed at time instant T2, where voltage $U_{R2}$ rises above the limit voltage. From the two crossings the phase sequence is known to be U1, U2, U3, phase U1 having a positive maximum between these two crossings. Since the positive maximum of phase U1 is referred to as zero angle for voltage space vector, the angle between the crossings is Angle12 = 0°. Timer is read and the value of T2 is determined. Now the time for the phase U1 positive maximum and for angle12 is calculated as T12 = (T2-T1)/2 = T2/2.

The third reference crossing is noticed at time instant T3, where phase U1 goes below the voltage limit. The timer is read and the value is stored in T3. Output frequency is calculated as f = 1/(3x(T3-T1) = 1/(3xT3). The voltage angle (in radians) at time instant T3 is also calculated as

$$Angle3 = Angle12 + k*(T3-T12)*2*\pi*f.$$

In this example the phase sequence is positive and thus k is 1.

Now the rotation direction, frequency and absolute angle of the voltage vector are known. The converter can now start modulation and synchronize itself with the mains supply using this information.

Another preferred embodiment of the invention is described with reference to Figure 6, which shows similar voltage waveforms as Figure 4. In this embodiment one of the voltages in the resistive circuits is selected to be the reference voltage to which other two voltages of the resistive circuits are compared. In this embodiment the first time instant and the second time instant are determined similarly as in the previously described embodiment. The difference is that the reference is not substantially constant, but is one of the voltages in the resistive circuits. In the example of Figure 6 the reference voltage is selected to be the voltage in the resistive circuit $U_{R1}$ that is derived from the phase voltage U1 of the supply.

According to this embodiment, when a crossing takes place (time instants T1' and T2'), i.e. a voltage drops below or rises above the reference, it is known that at that moment the third phase has either a positive or a negative peak value. By a third phase it is referred to that phase that is not the reference and not the voltage that crosses the reference. These phases are referred to as $U_{not\_crossT2}$ and $U_{not\_crossT1}$ at time instants T2' and T1', respectively.

It is thus already known that at time instant T1' one of the phases $U_{not\_crossT1}$ has a peak value. Also the phase in question is known. The direction (positive or negative) of the peak can also be directly determined. If the voltage in the resistive circuit of the phase that did not cross the reference voltage is higher than the reference voltage, then the peak is positive. And if the voltage in the resistive circuit of the phase that did not cross the reference voltage is lower than the reference voltage, the peak is negative. The information of the voltage of the third phase $U_{not\_crossT1}$ can be determined for example from the output of the comparator used in comparing the voltages. Thus already at the time instant T1' of the first crossing the angle of the voltage space vector is known.

At the time instant of the second reference crossing, similar conclusions are made as at the first time instant. Thus the angle of the alternating voltage space vector is known at the second time instant T2'.

Now two consecutive peaks are determined and thus the phase sequence can be determined. If the reference crossings have the same directions, i.e. the compared voltages rose above the reference at both time instants T1', T2' or the compared voltages dropped below the reference at both time instants T1', T2', then the frequency of the alternating supply voltage can be calculated as

$$f=1/(6*(T2'-T1')).$$

If, on the other hand, the directions of the two crossings are different (either up, down or down, up), then the frequency is calculated as

$$f=1/(3*(T2'-T1')).$$

Now the frequency, position and phase sequence are known and the angle of the space vector at any given time t can be calculated as

$$Angle(t)=Angle1 + k*(t-T1')*2*pi*f,$$

where k is either -1 or 1 depending on the direction of rotation and Angle1 is the angle of the space vector at the first time instant T1'.

Now referring more specifically to Figure 6, the following situation is considered. $U_{R1}$ is selected to be the reference voltage and it is thus derived directly from phase voltage U1 of the supply voltage. After the beginning of the method the first reference crossing takes place at time instant T1'. The phase that crosses the limit is phase $U_{R2}$. Thus the third phase $U_{not-crossT1}$ has a peak value at time instant T1'. Since voltage $U_{R2}$ relating to phase U crosses the reference ($U_{R1}$), the phase U3 has the peak value. At that moment $U_{R3}$ is lower than the reference and thus the peak is negative. As shown in Figure 5, the angle of the voltage space vector at time instant T1' is 60°.

Next, the following reference crossing takes place at time instant T2', where $U_{R3}$ becomes higher than the reference. The third phase $U_{not\_crossT2}$ is thus U2 and the voltage in the resistive circuit $U_{R2}$ is higher than the reference and therefore phase U2 has a positive peak value at time instant T2'. The angle of the voltage space vector is now 120°. The vector has thus rotated in the positive direction.

The consecutive crossings have same directions i.e. from below the reference to above it, and the frequency of the supply voltage can be calculated as f=1/(6*(T2'-T1')). Also the angle of the vector can be calculated as Angle(t) = 60° + (t-T1')*2*pi*f.

The above embodiment is favourable since only two comparators are required for the method.

It will be obvious to a person skilled in the art that, as the technology advances, the inventive concept can be implemented in various ways. The inventive idea can be applied to other types of mains side converters, e.g. to so called Vienna rectifier. The invention and its embodiments are not limited to the examples described above but may vary within the scope of the claims.

**Claims**

1. A method of determining a rotational state of a three-phase alternating supply voltage which is connected to a mains side converter, wherein the converter is connected to an intermediate voltage circuit (Udc+, Udc-) and comprises phase-specific upper and lower controllable switches (S11, S21, S31, S12, S22, S32), which are connected in series between the intermediate voltage circuit, free-wheeling diodes (D11, D21, D31, D12, D22, D32) connected in parallel with each of the controllable switches, and resistive circuits (R11, R12; R21, R22; R31, R32) connected in parallel with the lower controllable switches, **characterized in that** the method comprises the steps of

   selecting a voltage limit (Vref),

   comparing the voltages of the three-phase alternating supply in the resistive circuits (R11, R12; R21, R22; R31, R32) with the voltage limit (Vref),

   determining a first time instant (T1) when any of the voltages of the resistive circuits (R11, R12; R21, R22; R31, R32) crosses the voltage limit (Vref),

   determining a second time instant (T2) when any of the voltages of the resistive circuits (R11, R12; R21, R22; R31, R32) subsequently crosses the voltage limit (Vref),

   determining the phase sequence of the three-phase alternating supply voltage (U1, U2, U3) from the phases that crossed the voltage limit at the first and second time instants (T1, T2),

   determining the frequency of the three-phase alternating supply voltage from the determined time instants, the method being applicable when the voltage of the intermediate circuit is equal to or higher than the voltage of the three-phase alternating supply.

2. A method according to claim 1, **characterized in that** the voltage limit is selected to be one of the voltages ($U_{R1}$, $U_{R2}$, $U_{R3}$) produced by the alternating three-phase supply voltage in the resistive circuits (R11, R12; R21, R22; R31, R32), wherein the method comprises further steps of

   determining at the first time instant (T1) the phase ($U_{not\_crossT1}$) that did not cross the voltage limit, this phase having a positive or negative peak value at the first time instant (T1),

   comparing the voltage of the resistive circuit of the determined phase ($U_{not\_crossT1}$) with the voltage limit to determine if the peak is positive or negative,

   determining the angle (Angle1) of the alternating three-phase supply voltage space vector at the first time instant (T1),

   determining at the second time instant (T2) the phase ($U_{not\_crossT2}$) that did not cross the voltage limit, this phase having a positive or negative peak value at the second time instant (T2),

   comparing the voltage of the resistive circuit of the determined phase ($U_{not\_crossT2}$) with the voltage limit to determine if the peak is positive or negative,
determining the angle (Angle2) of the alternating three-phase supply voltage space vector at the second time instant (T2).

3. A method according to claim 2, **characterized in that** the peak value is determined to be a positive peak if the voltage in the resistive circuit of the phase that did not cross the voltage limit is higher than the voltage limit, and the peak value is determined to be a negative peak if the voltage in the resistive circuit of the phase that did not cross the voltage limit is lower than the voltage limit.

4. A method according to claim 2 or 3, **characterized in that** the frequency of the alternating three-phase supply voltage is calculated as

$$f = 1/(6*(T2-T1))$$

if the directions of the crossings of the voltage limit at the first and second time instants have a same direction, and as

$$f = 1/(3*(T2-T1))$$

if the directions of the crossings of the voltage limit at the first and second time instants have opposite directions.

5. A method according to claim 1, **characterized in that** the method comprises the further steps of
selecting the voltage limit to be a substantially constant value,
determining the supply voltage phase (U1, U2, U3) the voltage of which crossed the voltage limit (Vref) at the first time instant (T1),
determining the supply voltage phase (U1, U2, U3) the voltage of which crossed the voltage limit (Vref) at the second time instant (T2),
determining the phase sequence of the alternating three-phase supply voltage phases (U1, U2, U3) from the phases that crossed the voltage limit at the first and second time instants (T1, T2),
calculating a peak time instant (T12) which is in the middle of the first and second time instants (T1, T2),
determining from the information of the supply voltage phases that crossed the voltage limit at the first and second time instants which output phase (U1, U2, U3) has a peak value at the peak time instant (T12),
determining from the direction of the crossings whether the peak is a positive or a negative peak.
determining a third time instant (T3) when any of the voltages of the resistive circuits subsequently crosses the voltage limit (Vref).

6. A method according to claim 5, **characterized in that** the step of determining the frequency comprises the steps of calculating the frequency of the alternating three-phase supply voltage from the time difference between the first and third time instants.

7. A method according to claim 5, **characterized in that** the step of determining the frequency comprises the steps of determining further time instants when any of the voltages of the resistive circuits crosses the voltage limit (Vref), selecting either time instants in which the voltage rises above the voltage limit or time instants in which the voltage drops below the voltage limit, and
applying a phase-locked loop to the selected time instants, the output of which gives the frequency.

8. A method according to any one of the previous claims 5 to 7, **characterized in that** the method further comprises the step of determining the magnitude of the supply voltage.

9. A method according to claim 8, **characterized in that** the magnitude of the supply voltage is measured by measuring the voltages in the resistive circuits.

10. A method according to claim 8, **characterized in that** the determination of the magnitude of the supply voltage comprises steps of
feeding the voltages of the resistive circuits to a common point, and

measuring the voltage of the common point.

11. A method according to any one of the previous claims 5 to 10,
   **characterized in that** the voltage limit is adjustable.

12. A method according to any one of the previous claims 2 to 11, **characterized in that** the method comprises a further step of calculating the voltage angle at a given time instant from the frequency, peak time instant and the phase sequence.

**Patentansprüche**

1. Verfahren zur Bestimmung eines Rotationszustandes einer dreiphasigen Versorgungswechselspannung, die an einen mit dem Versorgungsnetz verbundenen Stromrichter angeschlossen ist, wobei der Stromrichter mit einem Spannungszwischenkreis (Udc+, Udc-) verbunden ist und phasenspezifische obere und untere steuerbare Schalter (S11, S21, S31, S12, S22, S32), die zwischen dem Spannungszwischenkreis in Serie geschaltet sind, mit jedem der steuerbaren Schalter parallel geschaltete Freilaufdioden (D11, D21, D31, D12, D22, D32) und mit den unteren steuerbaren Schaltern parallel geschaltete Widerstandsschaltungen (R11, R12; R21, R22; R31, R32) aufweist, **dadurch gekennzeichnet, dass** das Verfahren die Schritte aufweist:

   Auswählen eines Spannungsgrenzwerts (Vref),
   Vergleichen der Spannungen der dreiphasigen Wechselversorgung in den Widerstandsschaltungen (R11, R12; R21, R22; R31, R32) mit dem Spannungsgrenzwert (Vref),
   Bestimmen eines ersten Zeitpunkts (T1), wo eine der Spannungen der Widerstandsschaltungen (R11, R12; R21, R22; R31, R32) den Spannungsgrenzwert (Vref) überschreitet,
   Bestimmen eines zweiten Zeitpunkts (T2), wo eine der Spannungen der Widerstandsschaltungen (R11, R12; R21, R22; R31, R32) anschließend den Spannungsgrenzwert (Vref) überschreitet,
   Bestimmen der Phasensequenz der dreiphasigen Versorgungswechselspannung (U1, U2, U3) aufgrund der Phasen, die den Spannungsgrenzwert zum ersten und zweiten Zeitpunkt (T1, T2) überschritten,
   Bestimmen der Frequenz der dreiphasigen Versorgungswechselspannung aufgrund der bestimmten Zeitpunkte, welches Verfahren anwendbar ist, wenn die Spannung des Zwischenkreises gleich wie oder höher als die Spannung der dreiphasigen Wechselversorgung ist.

2. Verfahren nach Anspruch 1, **dadurch gekennzeichnet, dass** der Spannungsgrenzwert derart ausgewählt wird, dass er eine der Spannungen ($U_{R1}$, $U_{R2}$, $U_{R3}$) ist, die durch die dreiphasige Wechselversorgungsspannung in den Widerstandsschaltungen (R11, R12; R21, R22; R31, R32) erzeugt wird, wobei das Verfahren ferner die Schritte aufweist:

   Bestimmen der Phase ($U_{not\_crossT1}$), die den Spannungsgrenzwert nicht überschritt, zum ersten Zeitpunkt (T1), wobei diese Phase einen positiven oder negativen Spitzenwert zum ersten Zeitpunkt (T1) hat,
   Vergleichen der Spannung der Widerstandsschaltung der bestimmten Phase ($U_{not\_crossT1}$) mit dem Spannungsgrenzwert, um zu bestimmen, ob die Spitze positiv oder negativ ist,
   Bestimmen des Winkels (Angle 1) des Raumvektors der dreiphasigen Wechselversorgungsspannung zum ersten Zeitpunkt (T1),
   Bestimmen der Phase ($U_{not\_crossT2}$), die den Spannungsgrenzwert nicht überschritt, zum zweiten Zeitpunkt (T2), wobei diese Phase einen positiven oder negativen Spitzenwert zum zweiten Zeitpunkt (T2) hat,
   Vergleichen der Spannung der Widerstandsschaltung der bestimmten Phase ($U_{not\_crossT2}$) mit dem Spannungsgrenzwert, um zu bestimmen, ob die Spitze positiv oder negativ ist,
   Bestimmen des Winkels (Angle 2) des Raumvektors der dreiphasigen Wechselversorgungsspannung zum zweiten Zeitpunkt (T2).

3. Verfahren nach Anspruch 2, **dadurch gekennzeichnet, dass** der Spitzenwert als positive Spitze bestimmt wird, falls die Spannung in der Widerstandsschaltung der Phase, die den Spannungsgrenzwert nicht überschritt, höher als der Spannungsgrenzwert ist, und der Spitzenwert als negative Spitze bestimmt wird, falls die Spannung in der Widerstandsschaltung der Phase, die den Spannungsgrenzwert nicht überschritt, niedriger als der Spannungsgrenzwert ist.

4. Verfahren nach Anspruch 2 oder 3, **dadurch gekennzeichnet, dass** die Frequenz der dreiphasigen Wechselver-

sorgungsspannung als:

$$f = 1/(6*(T2-T1))$$

berechnet wird, falls die Richtungen der Überschreitungen des Spannungsgrenzwerts zum ersten und zweiten Zeitpunkt dieselbe Richtung aufweisen, und als

$$f = 1/(3*(T2-T1))$$

berechnet wird, falls die Richtungen der Überschreitungen des Spannungsgrenzwerts zum ersten und zweiten Zeitpunkt entgegengesetzte Richtungen aufweisen.

5. Verfahren nach Anspruch 1, **dadurch gekennzeichnet, dass** das Verfahren die weiteren Schritte aufweist:

   Auswählen des Spannungsgrenzwerts derart, dass er ein wesentlich fester Wert ist,
   Bestimmen der Versorgungsspannungsphase (U1, U2, U3), deren Spannung den Spannungsgrenzwert (Vref) zum ersten Zeitpunkt (T1) überschritt,
   Bestimmen der Versorgungsspannungsphase (U1, U2, U3), deren Spannung den Spannungsgrenzwert (Vref) zum zweiten Zeitpunkt (T2) überschritt,
   Bestimmen der Phasensequenz der dreiphasigen Versorgungswechselspannungsphasen (U1, U2, U3) aufgrund der Phasen, die den Spannungsgrenzwert zum ersten und zweiten Zeitpunkt (T1, T2) überschritten,
   Berechnen eines Spitzenzeitpunkts (T12), der in der Mitte des ersten und zweiten Zeitpunkts (T1, T2) ist,
   Bestimmen aufgrund der Informationen der Versorgungsspannungsphasen, die den Spannungsgrenzwert zum ersten und zweiten Zeitpunkt überschritten, welche Ausgangsphase (U1, U2, U3) einen Spitzenwert zum Spitzenzeitpunkt (T12) hat,
   Bestimmen aufgrund der Richtungen der Überschreitungen, ob die Spitze eine positive oder negative Spitze ist,
   Bestimmen eines dritten Zeitpunkts (T3), wo eine der Spannungen der Widerstandsschaltungen anschließend den Spannungsgrenzwert (Vref) überschreitet.

6. Verfahren nach Anspruch 5, **dadurch gekennzeichnet, dass** der Schritt des Bestimmens der Frequenz die Schritte aufweist:

   Berechnen der Frequenz der dreiphasigen Versorgungswechselspannung aufgrund des Zeitunterschieds zwischen dem ersten und dritten Zeitpunkt.

7. Verfahren nach Anspruch 5, **dadurch gekennzeichnet, dass** der Schritt des Bestimmens der Frequenz die Schritte aufweist:

   Bestimmen von weiteren Zeitpunkten, wo eine der Spannungen der Widerstandsschaltungen den Spannungsgrenzwert (Vref) überschreitet,
   Auswählen von entweder Zeitpunkten, zu denen die Spannung über den Spannungsgrenzwert steigt, oder Zeitpunkten, zu denen die Spannung unter den Spannungsgrenzwert fällt, und
   Anwenden eines Phasenregelkreises auf die ausgewählten Zeitpunkte, dessen Ausgang die Frequenz bereitstellt.

8. Verfahren nach einem der vorhergehenden Ansprüche 5 bis 7, **dadurch gekennzeichnet, dass** das Verfahren ferner den Schritt des Bestimmens der Größe der Versorgungsspannung aufweist.

9. Verfahren nach Anspruch 8, **dadurch gekennzeichnet, dass** die Größe der Versorgungsspannung derart gemessen wird, dass die Spannungen in den Widerstandsschaltungen gemessen werden.

10. Verfahren nach Anspruch 8, **dadurch gekennzeichnet, dass** das Bestimmen der Größe der Versorgungsspannung die Schritte aufweist:

**EP 2 043 239 B1**

Speisen der Spannungen der Widerstandsschaltungen zu einem gemeinsamen Punkt und
Messen der Spannung des gemeinsamen Punkts.

**11.** Verfahren nach einem der vorhergehenden Ansprüche 5 bis 10, **dadurch gekennzeichnet, dass** der Spannungsgrenzwert einstellbar ist.

**12.** Verfahren nach einem der vorhergehenden Ansprüche 2 bis 11, **dadurch gekennzeichnet, dass** das Verfahren einen weiteren Schritt aufweist, in dem der Spannungswinkel zu einem gegebenen Zeitpunkt aufgrund der Frequenz, des Spitzenzeitpunkts und der Phasensequenz berechnet wird.

**Revendications**

**1.** Procédé destiné à déterminer un état de rotation d'une tension d'alimentation alternative triphasée, laquelle est connectée à un convertisseur côté réseau électrique, dans lequel le convertisseur est connecté à un circuit de tension intermédiaire (Udc+, Udc-) et comporte des commutateurs contrôlables supérieurs et inférieurs spécifiques aux phases (S11, S21, S31, S 12, S22, S32), lesquels sont connectés en série entre le circuit de tension intermédiaire, des diodes libres (D11, D21, D31, D 12, D22, D32) connectées en parallèle à chacun des commutateurs contrôlables, et des circuits résistifs (R11, R12 ; R21, R22 ; R31, R32) connectés in parallèle aux commutateurs contrôlables inférieurs, **caractérisé en ce que** le procédé comporte les étapes ci-après consistant à :

sélectionner une limite de tension (Vref) ;
comparer les tensions de l'alimentation alternative triphasée dans les circuits résistifs (R11, R12 ; R21, R22 ; R31, R32) avec la limite de tension (Vref),
déterminer un premier instant temporel (T1) lorsque l'une quelconque des tensions des circuits résistifs (R11, R12 ; R21, R22 ; R31, R32) franchit la limite de tension (Vref),
déterminer un deuxième instant temporel (T2) lorsque l'une quelconque des tensions des circuits résistifs (R11, R12 ; R21, R22 ; R31, R32) franchit subséquemment la limite de tension (Vref),
déterminer la séquence de phases de la tension d'alimentation alternative triphasée (U1, U2, U3) à partir des phases qui ont franchi la limite de tension aux premier et deuxième instants temporels (T1, T2),
déterminer la fréquence de la tension d'alimentation alternative triphasée à partir des instants temporels déterminés, le procédé étant applicable lorsque la tension du circuit intermédiaire est égale ou supérieure à la tension de l'alimentation alternative triphasée.

**2.** Procédé selon la revendication 1, **caractérisé en ce que** la limite de tension est choisie de manière à être l'une des tensions ($U_{R1}$, $U_{R2}$, $U_{R3}$) générées par la tension d'alimentation triphasée alternative dans les circuits résistifs (R11, R12 ; R21, R22 ; R31, R32), dans lequel le procédé comporte en outre les étapes ci-après consistant à :

déterminer au premier instant temporel (T1) la phase ($U_{not\_crossT1}$) qui n'a pas franchi la limite de tension, cette phase présentant une valeur de crête positive ou négative au premier instant temporel (T1) ;
comparer la tension du circuit résistif de la phase déterminée ($U_{not\_crossT1}$) avec la limite de tension en vue de déterminer si la crête est positive ou négative,
déterminer l'angle (Angle1) du vecteur spatial de tension d'alimentation triphasée alternative au premier instant temporel (T1),
déterminer, au deuxième instant temporel (T2), la phase ($U_{not\_crossT2}$) qui n'a pas franchi la limite de tension, cette phase présentant une valeur de crête positive ou négative au deuxième instant temporel (T2),
comparer la tension du circuit résistif de la phase déterminée ($U_{not\_crossT2}$) avec la limite de tension pour déterminer si la crête est positive ou négative,
déterminer l'angle (Angle2) du vecteur spatial de tension d'alimentation triphasée alternative au deuxième instant temporel (T2).

**3.** Procédé selon la revendication 2, **caractérisé en ce que** la valeur de crête est déterminée comme étant une crête positive lorsque la tension dans le circuit résistif de la phase qui n'a pas franchi la limite de tension est supérieure à la limite de tension, et la valeur de crête est déterminée comme étant une valeur de crête négative lorsque la tension dans le circuit résistif de la phase qui n'a pas franchi la limite de tension est inférieure à la limite de tension.

**4.** Procédé selon la revendication 2 ou 3, **caractérisé en ce que** la fréquence de la tension d'alimentation triphasée alternative est calculée selon l'équation ci-dessous :

**11**

$$f = 1 / (6 * (T2 - T1))$$

si les directions des franchissements de la limite de tension aux premier et deuxième instants temporels ont une même direction, et selon l'équation ci-dessous :

$$f = 1 / (3 * (T2 - T1))$$

si les directions des franchissements de la limite de tension aux premier et deuxième instants temporels ont des directions opposées.

5. Procédé selon la revendication 1, **caractérisé en ce que** le procédé comporte en outre les étapes ci-après consistant à :

sélectionner la limite de tension comme étant une valeur sensiblement constante,
déterminer la phase de tension d'alimentation (U1, U2, U3) dont la tension a franchi la limite de tension (Vref) au premier instant temporel (T1),
déterminer la phase de tension d'alimentation (U1, U2, U3) dont la tension a franchi la limite de tension (Vref) au deuxième instant temporel (T2),
déterminer la séquence de phases des phases de tension d'alimentation triphasée alternative (U1, U2, U3) à partir des phases qui ont franchi la limite de tension aux premier et deuxième instants temporels (T1, T2),
calculer un instant temporel de crête (T12) qui se situe au milieu des premier et deuxième instants temporels (T1, T2),
déterminer, à partir des informations des phases de tension d'alimentation qui ont franchi la limite de tension aux premier et deuxième instants temporels, quelle phase de sortie (U1, U2, U3) présente une valeur de crête à l'instant temporel de crête (T12),
déterminer à partir des directions des franchissements si la crête est une crête positive ou une crête négative,
déterminer un troisième instant temporel (T3) lorsque l'une quelconque des tensions des circuits résistifs franchit subséquemment la limite de tension (Vref).

6. Procédé selon la revendication 5, **caractérisé en ce que** l'étape consistant à déterminer la fréquence comporte les étapes consistant à :

calculer la fréquence de la tension d'alimentation triphasée alternative à partir de la différence temporelle entre les premier et troisième instants temporels.

7. Procédé selon la revendication 5, **caractérisé en ce que** l'étape consistant à déterminer la fréquence comporte les étapes ci-dessous consistant à :

déterminer des instants temporels supplémentaires lorsque l'une quelconque des tensions des circuits résistifs franchit la limite de tension (Vref),
sélectionner soit des instants temporels pour lesquels la tension passe au-dessus de la limite de tension, soit des instants temporels pour lesquels la tension passe sous la limite de tension, et
appliquer une boucle à verrouillage de phase aux instants temporels sélectionnés dont la sortie donne la fréquence.

8. Procédé selon l'une quelconque des revendications 5 à 7, **caractérisé en ce que** le procédé comporte en outre l'étape consistant à déterminer l'amplitude de la tension d'alimentation.

9. Procédé selon la revendication 8, **caractérisé en ce que** l'amplitude de la tension d'alimentation est mesurée en mesurant les tensions dans les circuits résistifs.

10. Procédé selon la revendication 8, **caractérisé en ce que** la détermination de l'amplitude de la tension d'alimentation comporte les étapes ci-dessous consistant à :

introduire les tensions des circuits résistifs au niveau d'un point commun, et
mesurer la tension du point commun.

**11.** Procédé selon l'une quelconque des revendications 5 à 10, **caractérisé en ce que** la limite de tension est réglable.

**12.** Procédé selon l'une quelconque des revendications 2 à 11, **caractérisé en ce que** le procédé comporte en outre une étape consistant à calculer l'angle de tension à un instant temporel donné à partir de la fréquence, de l'instant temporel de crête et de la séquence de phases.

FIG 1

EP 2 043 239 B1

FIG 2

FIG 3

FIG 8

FIG 4

FIG 5

FIG 7

FIG 6

EP 2 043 239 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9403965 A
- DE 10048441
- US 20030075997 A1